# EUROPÄISCHE PATENTSCHRIFT

(11) **EP 3 967 986 B1**
(45) Veröffentlichungstag und Bekanntmachung des Hinweises auf die Patenterteilung: **03.07.2024**
(21) Anmeldenummer: 21191051.8
(22) Anmeldetag: 12.08.2021
(51) Int. Cl.: G01F 1/60, G01F 1/58, G01F 25/10

(54) **MAGNETISCH-INDUKTIVES DURCHFLUSSMESSGERÄT UND VERFAHREN ZUR FUNKTIONSÜBERWACHUNG EINES MAGNETISCH-INDUKTIVEN DURCHFLUSSMESSGERÄTES**
MAGNETIC-INDUCTIVE FLOW MEASURING DEVICE AND METHOD FOR MONITORING THE FUNCTION OF A MAGNETIC-INDUCTIVE FLOW MEASURING DEVICE
DÉBITMÈTRE MAGNÉTIQUE-INDUCTIF ET PROCÉDÉ DE SURVEILLANCE DU FONCTIONNEMENT D'UN DÉBITMÈTRE MAGNÉTIQUE-INDUCTIF

(30) Priorität: 09.09.2020 DE 102020123492
(43) Veröffentlichungstag der Anmeldung: 16.03.2022
(73) Patentinhaber: Krohne Messtechnik GmbH, 47058 Duisburg (DE)
(72) Erfinder: Brockhaus, Helmut, 46145 Oberhausen (DE); Dabrowski, Markus, 47269 Duisburg (DE); Kaisler, Ralf, 46395 Bocholt (DE)
(74) Vertreter: Gesthuysen Patentanwälte

(56) Entgegenhaltungen:
- DE-A1-102014 119 453
- DE-T2- 69 804 857
- JP-A- S52 122 147
- US-A1- 2010 288 054

## Beschreibung

Die Erfindung betrifft ein magnetisch-induktives Durchflussmessgerät, mit einem Messrohr zum Führen eines elektrisch leitfähigen Mediums, mit einer Magnetfelderzeugungseinrichtung zum Erzeugen eines das Medium durchsetzenden Magnetfeldes, mit zwei Elektroden zum Abgreifen einer in dem Medium induzierten Messspannung, mit einem mit dem Medium elektrisch verbundenen Masseelement und mit einer Auswerteeinheit, wobei die Elektroden über Elektrodenleitungen mit der Auswerteeinheit verbunden sind und wobei das Masseelement über eine erste Masseleitung mit der Auswerteeinheit verbunden ist zum Potentialausgleich zwischen dem elektrisch leitfähigen Medium und einem Bezugspotential der Auswerteeinheit. Zudem betrifft die Erfindung ein Verfahren zur Funktionsüberwachung eines magnetisch-induktiven Durchflussmessgerätes.

Die in Rede stehenden magnetisch-induktiven Durchflussmessgeräte sind aus dem Stand der Technik bekannt und dienen zur Bestimmung des Durchflusses eines Mediums. Das Messrohr und die Elektroden stellen praktisch den Sensor des magnetisch-induktiven Durchflussmessgerätes dar. Die Auswerteeinheit umfasst elektronische Mittel, wie zum Beispiel Verstärker, Filter, AD-/DA-Wandler, usw., zur Auswertung des interessierenden Messsignals, also der induzierten Messspannung zwischen den beiden Elektroden, wobei die Auswerteeinheit üblicherweise beabstandet von dem Sensor angeordnet ist. Die elektrische Verbindung zwischen den Elektroden und der Auswerteeinheit wird durch die Elektrodenleitungen hergestellt.

Der Sensor und die Auswerteeinheit werden auf ein gemeinsames elektrisches Bezugspotential gelegt, indem über die erste Masseleitung eine elektrische Verbindung zwischen dem Masseelement und der Auswerteeinheit hergestellt wird.

Das Masseelement wird entweder realisiert durch eine Masseelektrode, also eine dritte Elektrode, oder über einen oder mehrere Masseringe, wobei entweder ein Massering im Einlaufbereich oder im Auslaufbereich angeordnet ist oder sowohl im Einlaufbereich als auch im Auslaufbereich ein Massering angeordnet ist. Alternativ können die Masseringe auch durch unbeschichtete Abschnitte des Messrohres realisiert sein.

Das Dokument DE 10 2014 119453 A1 offenbart ein Verfahren zur Defekterkennung der Signalleitung zwischen einer Elektrode und einer Mess- und/oder Auswerteeinheit eines magnetisch-induktiven Durchflussmessgerätes, wobei auch eine Kabelbrechung der Verbindungsleitung zur Masseelektrode überprüft werden kann.

Das Dokument DE 698 04 857 T2 offenbart ein magnetisch-induktives Durchflussmessgerät und ein Verfahren zur Überprüfung der Elektrodenintegrität.

Um einen korrekten Potentialausgleich zwischen dem Medium und der Auswerteeinheit sicherzustellen, ist es notwendig, dass das Masseelement zuverlässig kontaktiert ist. Ist die elektrische Verbindung zwischen dem Masseelement und der Auswerteeinheit nicht gleichbleibend sichergestellt - lose Verbindung, Wackelkontakt, Kabelbruch, veränderlicher Widerstand -, hat dies unmittelbaren negativen Einfluss auf das Messergebnis.

Der Erfindung liegt demnach die Aufgabe zugrunde, ein magnetisch-induktives Durchflussmessgerät anzugeben, das auf einfache Weise einen Überprüfungstest einer zuverlässigen Verbindung zwischen Masseelement und Auswerteeinheit und einen Funktionstest der Elektrodenverbindungen durchführen kann. Zudem liegt der Erfindung die Aufgabe zugrunde, ein Verfahren bereitzustellen, mit dem auf einfache und zuverlässige Art und Weise ein Funktionstest durchgeführt werden kann.

Die Aufgabe ist erfindungsgemäß dadurch gelöst, nämlich mit den Merkmalen des Patentanspruchs 1, dass das Masseelement zumindest mittelbar über eine zweite Masseleitung mit der Auswerteeinheit verbunden ist, dass die erste Masseleitung und die zweite Masseleitung Bestandteil eines Überprüfungsstrompfades eines Überprüfungsstromkreises zur Überprüfung der Verbindung zwischen Masseelement und Auswerteeinheit sind und dass die Auswerteeinheit derart ausgestaltet ist, dass sie die Verbindung zwischen Masseelement und Auswerteeinheit überprüft.

In einer erfindungsgemäßen ersten Variante des erfindungsgemäßen magnetisch-induktiven Durchflussmessgerätes ist die Auswerteeinheit derart ausgestaltet, dass sie einen Überprüfungsstrom in den Überprüfungsstromkreis einprägt und die abfallende Spannung misst. Wenn es heißt, dass die abfallende Spannung gemessen wird, dann ist damit gemeint, dass die an einem Überprüfungsstrompfad abfallende Spannung gemessen wird, wobei der Überprüfungsstrompfad Teil des Überprüfungsstromkreises ist und die beiden Masseleitungen Teil des Überprüfungsstrompfades sind. In einer erfindungsgemä-ßen zweiten - alternativen - Variante ist die Auswerteeinheit derart ausgestaltet, dass sie eine Überprüfungsspannung an den Überprüfungsstromkreis, bzw. an den Überprüfungsstrompfad anlegt und den Strom misst. In beiden Fällen ist in der Auswerteeinheit ein Referenzwert für die abgefallene Spannung oder den fließenden Strom für den Gutzustand der Verbindung zwischen Masseelement und Auswerteeinheit hinterlegt. Die angelegte Spannung oder der eingeprägte Strom können als Gleichsignal vorgesehen sein. In einer bevorzugten Ausführungsform werden sie als harmonisches Wechselsignal generiert und die Impedanz des Überprüfungsstrompfades bestimmt, insbesondere als zweiwertige Größe (Scheinwiderstand, Phasenlage oder Wirk- und Blindwiderstand). In diesem Fall ist in der Auswerteeinheit ein Referenzwert für die Impedanz im Gutzustand des Gerätes hinterlegt. Die Auswerteeinheit ist ferner so ausgestaltet, dass sie den gemessenen Wert mit dem Referenzwert vergleicht.

Beim Auftreten einer Abweichung über eine vorgegebene Toleranzgrenze hinaus kann die Auswerteeinheit eine Fehlermeldung ausgeben. Die Fehlermeldung wird in einer Variante als akustisches Signal ausgegeben, in einer weiteren Variante wird die Fehlermeldung als optisches Signal ausgegeben. In einer weiter bevorzugten Variante wird die Fehlermeldung als eine Kombination eines optischen und akustischen Signals ausgegeben. In einer weiter bevorzugten Variante wird die Fehlermeldung als Fehlersignal über eine Schnittstelle des magnetisch-induktiven Durchflussmessgerätes ausgeben.

In einer ganz besonders bevorzugten Ausgestaltung des magnetisch-induktiven Durchflussmessgerätes bilden die erste Elektrode und das Masseelement einen ersten Elektrodenmesspfad und die zweite Elektrode und das Masseelement einen zweiten Elektrodenmesspfad. Die Auswerteeinheit ist derart ausgestaltet, dass sie eine impedanzabhängige elektrische Größe des ersten Elektrodenmesspfades ermittelt und dass sie eine impedanzabhängige Größe des zweiten Elektrodenmesspfades ermittelt. Eine impedanzabhängige Größe kann hier beispielsweise eine abfallende Spannung (bei einem eingeprägten Strom) oder ein fließender Strom (bei einer angelegten Spannung) sein, insbesondere kann eine impedanzabhängige elektrische Größe auch die Impedanz des entsprechenden Elektrodenmesspfades selbst sein. Ferner ist die Auswerteeinheit derart ausgestaltet, dass sie die ermittelten impedanzabhängigen elektrischen Größen miteinander und/oder mit einem vorgegebenen Referenzwert vergleicht und bei einer festgestellten Abweichung über einen vorgegebenen Toleranzbereich hinaus ein Fehlersignal ausgibt. Diese erfindungsgemäße Ausgestaltung des magnetisch-induktiven Durchflussmessgerätes ermöglicht, einen Elektrodenfehler zu erkennen und einer bestimmten Elektrode zuzuordnen, da durch die Überprüfung der Masseleitungen ein sich auf beide Elektrodenmesspfade gleichermaßen auswirkender Fehler ausgeschlossen werden kann. Als Referenzwert kann hier beispielsweise ein vorhergehender Messwert verwendet werden.

Eine besonders bevorzugte Ausgestaltung des erfindungsgemäßen magnetisch-induktiven Durchflussmessgerätes zeichnet sich dadurch aus, dass das Masseelement einen Anschluss aufweist und dass die erste Masseleitung über den Anschluss mit dem Masseelement verbunden ist und dass die zweite Masseleitung mit der ersten Masseleitung verbunden ist. Die zweite Masseleitung ist somit mittelbar über die erste Masseleitung mit dem Masseelement verbunden. Eine derartige Ausgestaltung weist den Vorteil auf, dass der Montageaufwand sehr gering gehalten ist und dass zudem bestehende magnetisch-induktive Durchflussmessgeräte auf einfache Weise auf erfinderische Art umgerüstet werden können.

Um auch überprüfen zu können, ob der Anschluss zwischen Masseleitung und Masseelement unbeschädigt ist, sieht eine weitere besondere Ausgestaltung des erfindungsgemäßen magnetisch-induktiven Durchflussmessgerätes vor, dass das Masseelement einen ersten Anschluss und einen zweiten Anschluss aufweist und die erste Masseleitung über den ersten Anschluss mit dem Masseelement verbunden ist und die zweite Masseleitung über den zweiten Anschluss mit dem Masseelement verbunden ist. Je mehr Bestandteile der Überprüfungsstromkreis umfasst, desto weiterreichend kann eine Überprüfung der Verbindung zwischen Masseelement und Auswerteeinheit realisiert werden. Bei der beschriebenen Ausgestaltung wird entsprechend neben der Intaktheit der Masseleitungen auch der Anschluss, also der Kontakt zwischen Masseelement und Masseleitung überprüft.

Eine weitere Ausgestaltung des erfindungsgemäßen magnetisch-induktiven Durchflussmessgerätes ist dadurch gekennzeichnet, dass die Elektrodenleitungen und die Masseleitungen zu einem Mehrleiterkabel zusammengefasst sind. Sämtliche Leitungen werden also über ein Mehrleiterkabel zu der Auswerteeinheit geführt. Durch diese Ausgestaltung können indirekt die Elektrodenleitungen überprüft werden.

Neben dem magnetisch-induktiven Durchflussmessgerät betrifft die Erfindung ebenfalls ein Verfahren zur Funktionsüberwachung eines magnetisch-induktiven Durchflussmessgerätes. Das erfindungsgemäße Verfahren wird an einem magnetisch-induktiven Durchflussmessgerät durchgeführt, das ein Messrohr zum Führen eines elektrisch leitfähigen Mediums, eine Magnetfelderzeugungseinrichtung zum Erzeugen eines das Medium durchsetzenden Magnetfeldes, zwei Elektroden zum Abgreifen einer in dem Medium induzierten Messspannung, ein mit dem Medium elektrisch verbundenes Masseelement und eine Auswerteeinheit aufweist, wobei die Elektroden über Elektrodenleitungen mit der Auswerteeinheit verbunden sind und wobei das Masseelement über eine erste Masseleitung mit der Auswerteeinheit verbunden ist zum Potentialausgleich zwischen dem elektrisch leitfähigen Medium und einem Bezugspotential der Auswerteeinheit und wobei das Masseelement zumindest mittelbar über eine zweite Masseleitung mit der Auswerteeinheit verbunden ist, wobei die erste Masseleitung und die zweite Masseleitung Bestandteil eines Überprüfungsstrompfades eines Überprüfungsstromkreises zur Überprüfung der Verbindung zwischen Masseelement und Auswerteeinheit sind.

Das erfindungsgemäße Verfahren zeichnet sich dadurch aus, dass zunächst in einem Messschritt die Auswerteeinheit wenigstens einen der beiden folgenden Verfahrensschritte durchführt:
- Einprägen eines Überprüfungsstroms in den Überprüfungsstromkreis und Messen der in dem Überprüfungsstrompfad abfallenden Spannung, oder
- Anlegen einer Überprüfungsspannung an den Überprüfungsstrompfad und Messen des im Überprüfungsstromkreis fließenden Stroms.

In einem Vergleichsschritt vergleicht die Auswerteeinheit den gemessenen Wert für die abgefallene Spannung und/oder den fließenden Strom und/oder eine berechnete Impedanz oder eine andere impedanzabhängige elektrische Größe des Überprüfungsstrompfades mit einem Referenzwert für die abfallende Spannung, den resultierenden Strom, die Impedanz oder die andere impedanzabhängige elektrische Größe für den Gutzustand der Verbindung zwischen Masseelement und Auswerteeinheit. Beim Abweichen der Werte über einen vorgegebenen Toleranzbereich hinaus wird in einem Ausgabeschritt die Auswerteeinheit ein Fehlersignal ausgegeben.

Eine besonders bevorzugte Weiterentwicklung des erfindungsgemäßen Verfahrens ermöglicht das Erkennen eines Elektrodenfehlers einer der Elektroden des magnetisch-induktiven Durchflussmessgerätes. Das magnetisch-induktive Durchflussmessgerät weist eine erste Elektrode und eine zweite Elektrode auf. Ein Elektrodenfehler kann beispielsweise eine defekte Verbindung von Elektrode und Elektrodenleitung sein. Das magnetisch-induktive Durchflussmessgerät weist einen ersten Elektrodenmesspfad und einen zweiten Elektrodenmesspfad auf, wobei die erste Elektrode und das Masseelement Teil des ersten Elektrodenmesspfades sind und wobei die zweite Elektrode und das Masseelement Teil des zweiten Elektrodenmesspfades sind. Erfindungsgemäß ermittelt die Auswerteeinheit eine impedanzabhängige elektrische Größe des ersten Elektrodenmesspfades und/oder eine impedanzabhängige elektrische Größe des zweiten Elektrodenmesspfades in einem Ermittlungsschritt. Eine impedanzabhängige Größe kann hierbei beispielsweise ein fließender Strom beim Anlegen einer Spannung an den Elektrodenmesspfad sein. Beispielsweise kann eine impedanzabhängige Größe auch eine abfallende Spannung sein, wenn ein Strom eingeprägt wird. Eine impedanzabhängige Größe kann aber beispielsweise auch die Impedanz des Elektrodenmesspfades selbst sein. In einem Vergleichsschritt vergleicht die Auswerteeinheit die ermittelten impedanzabhängigen elektrischen Größen miteinander und/oder mit einem vorgegebenen Vergleichswert. In einem Signalausgabeschritt gibt die Auswerteeinheit bei einer festgestellten Abweichung über einen vorgegebenen Toleranzbereich hinaus ein Elektrodenfehlersignal aus.

In einer weiteren Weiterbildung identifiziert die Auswerteeinheit in einem Identifizierungsschritt die Elektrode, bei der die ermittelte impedanzabhängige elektrische Größe auf einen höheren Impedanzwert hinweist, als fehlerhafte Elektrode. Wird als impedanzabhängige elektrische Größe eine abfallende Spannung in einem Elektrodenmesspfad ermittelt, so weist eine Erhöhung der Spannung auf eine höhere Impedanz hin. Wird hingegen ein fließender Strom als impedanzabhängige elektrische Größe ermittelt, so deutet ein geringerer Stromwert auf einen höheren Impedanzwert hin.

Im Einzelnen gibt es nun eine Mehrzahl an Möglichkeiten, das erfindungsgemäße magnetisch-induktive Durchflussmessgerät auszugestalten und weiterzubilden. Hierzu wird verwiesen auf die dem Patentanspruch 1 nachgeordneten Patentansprüche sowie auf die Beschreibung bevorzugter Ausführungsbeispiele in Verbindung mit der Zeichnung. In der Zeichnung zeigen
- Fig. 1: eine erste Ausgestaltung eines magnetisch-induktiven Durchflussmessgerätes,
- Fig. 2: eine zweite Ausgestaltung eines magnetisch-induktiven Durchflussmessgerätes,
- Fig. 3: eine dritte Ausgestaltung eines magnetisch-induktiven Durchflussmessgerätes,
- Fig. 4: ein Blockdiagramm eines Verfahrens zur Funktionsüberwachung eines magnetisch-induktiven Durchflussmessgerätes und
- Fig. 5: ein Blockdiagramm eines weiterentwickelten Verfahrens zur Funktionsüberwachung eines magnetisch-induktiven Durchflussmessgerätes.

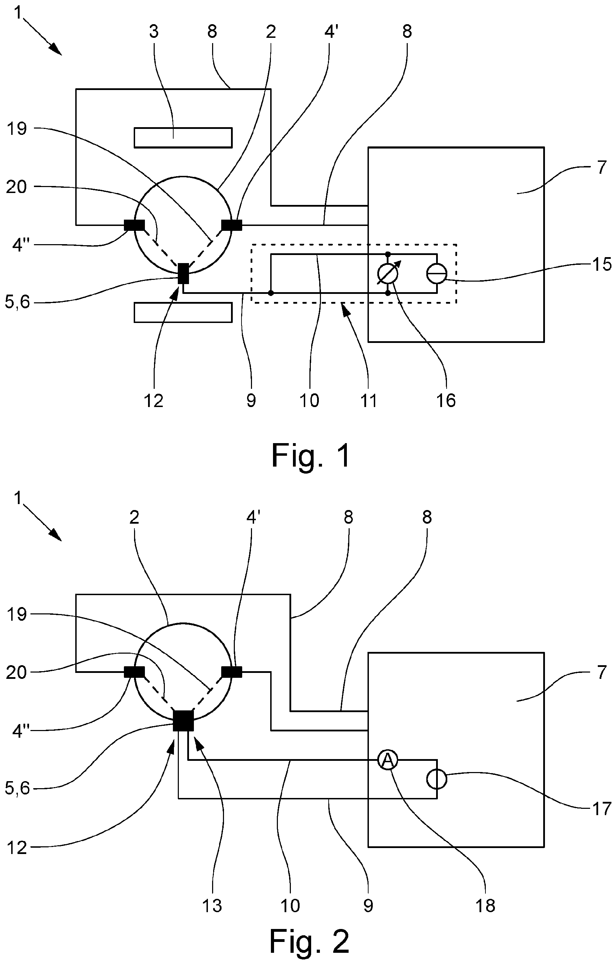

Fig. 1 zeigt ein magnetisch-induktives Durchflussmessgerät 1 mit einem Messrohr 2 zum Führen eines elektrisch leitfähigen Mediums. Zudem weist das magnetisch-induktive Durchflussmessgerät 1 eine Magnetfelderzeugungseinheit 3 zum Erzeugen eines das Medium durchsetzenden Magnetfeldes auf. Zwei Elektroden 4', 4", die einander diametral gegenüber an dem Messrohr 2 angeordnet sind, dienen zum Abgreifen einer in dem Medium induzierten Messspannung. Neben den Elektroden 4', 4" weist das magnetisch-induktive Durchflussmessgerät 1 ein Masseelement 5 auf, das elektrisch mit dem Medium verbunden ist.

In der dargestellten Ausführungsform ist das Masseelement 5 als Masseelektrode 6 realisiert. Eine Auswerteeinheit 7 ist ebenfalls vorgesehen. Die Elektroden 4 sind über Elektrodenleitungen 8 mit der Auswerteeinheit 7 verbunden. Das Masseelement 5 ist zum Potentialausgleich zwischen dem elektrisch leitfähigen Medium und einem Bezugspotential der Auswerteeinheit über eine erste Masseleitung 9 mit der Auswerteeinheit 7 verbunden. Zudem ist das Masseelement 5 mittelbar über eine zweite Masseleitung 10 mit der Auswerteeinheit 7 verbunden.

Die erste Masseleitung 9 und die zweite Masseleitung 10 sind Bestandteil eines Überprüfungsstromkreises 11, der in Fig. 1 gestrichelt eingerahmt ist. Mit Hilfe des Überprüfungsstromkreises 11 kann die Verbindung zwischen dem Masseelement 5 und der Auswerteeinheit 7 überprüft werden, insbesondere können Beschädigungen der Masseleitungen 9, 10 oder der Kontaktierung überprüft werden. Hierzu ist die Auswerteeinheit 7 derart ausgestaltet, dass sie die Verbindung zwischen Masseelement 7 und Auswerteeinheit 7 überprüft. Bei der in Fig. 1 dargestellten Ausführungsform ist die Masseleitung 9 über einen Anschluss 12 mit dem Masseelement 5 verbunden. Die zweite Masseleitung 10 ist nicht unmittelbar mit dem Masseelement 5 verbunden, sondern ist mit der ersten Masseleitung 9 verbunden.

Die Auswerteeinheit ist bei der Fig. 1 derart ausgestaltet, dass sie einen Überprüfungsstrom in den Überprüfungsstromkreis 11 einprägt. Hierzu ist eine Stromquelle 15 vorgesehen. Zudem misst sie die abfallende Spannung in dem Überprüfungsstromkreis, bzw. in einem Überprüfungsstrompfad, der Teil des Überprüfungsstromkreises ist, mittels eines Spannungsmessgerätes 16. In der Auswerteeinheit 7 ist ein Referenzwert für die abfallende Spannung für den Gutzustand der Verbindung hinterlegt. Die Auswerteeinheit 7 ist entsprechend derart ausgestaltet, dass sie die gemessene abgefallene Spannung mit dem Referenzwert vergleicht und bei Abweichen über einen vorgegebenen Toleranzwert hinaus ein Fehlersignal ausgibt.

Fig. 2 zeigt eine weitere Ausgestaltung eines magnetisch-induktiven Durchflussmessgerätes 1. Im Gegensatz zu dem in Fig. 1 dargestellten Ausführungsbeispiel ist hier die zweite Masseleitung 10 über einen separaten zweiten Anschluss 13 mit dem Masseelement 5 verbunden.

Zudem ist die Auswerteeinheit 7 derart realisiert, dass sie über eine Spannungsquelle 17 eine Spannung an einen Überprüfungsstrompfad, der Bestandteil des Überprüfungsstromkreises 11 ist, anlegt und den abfallenden Strom mittels eines Strommessgerätes 18 misst. In der Auswerteeinheit 7 ist dann ein Referenzwert für den abfallenden Strom im Gutzustand der Verbindung zwischen Masseelement 5 und Auswerteeinheit 7 hinterlegt. Ein Abgleich des gemessenen Stromwertes und des Referenzwertes wird von der Auswerteeinheit 7 vorgenommen und auch hier wird bei einer Abweichung bei einem vorgegebenen Toleranzbereich hinaus ein Fehlersignal ausgegeben. Das Fehlersignal kann beispielsweise durch ein akustisches Signal ausgegeben werden, ebenfalls denkbar ist die Ausgabe eines optischen Signals. Die Ausgestaltung des magnetisch-induktiven Durchflussmessgerätes 1 wie in Fig. 2 gezeigt, hat den Vorteil, dass auch die funktionsfähige Kontaktierung der Masseleitung 9 über den Anschluss 12 an das Masseelement 5 überprüft werden kann. Da sowohl der erste Anschluss 12 als auch der zweite Anschluss 13 Teil des Überprüfungsstromkreises sind, erschließt sich hierdurch ein größerer Überprüfungsbereich.

Sowohl in Fig. 1 als auch in Fig. 2 sind ein erster Elektrodenmesspfad 19 und ein zweiter Elektrodenmesspfad 20 dargestellt. Der erste Elektrodenmesspfad 19 umfasst die erste Elektrode 4' und das Masseelement 5, der zweite Elektrodenmesspfad 20 umfasst die zweite Elektrode 4" und das Masseelement 5. Die Steuer- und Auswerteeinheit 7 ist derart ausgestaltet, dass sie eine impedanzabhängige elektrische Größe des ersten Elektrodenmesspfades 19 und des zweiten Elektrodenmesspfades 20 ermittelt. Bei den dargestellten Ausführungsbeispielen wird die Impedanz der Elektrodenmesspfade 19, 20 selbst ermittelt. Ferner ist die Steuer- und Auswerteeinheit 7 derart ausgestaltet, dass sie die ermittelten Werte mit einem Referenzwert vergleicht und beim Abweichen über einen vorgegebenen Toleranzbereich hinaus ein Elektrodenfehlersignal ausgibt. Die Steuer- und Auswerteeinheit 7 identifiziert eine Elektrode 4', 4" vorliegend dann als fehlerhaft, wenn der ermittelte Impedanzwert nach oben von dem Referenzwert abweicht.

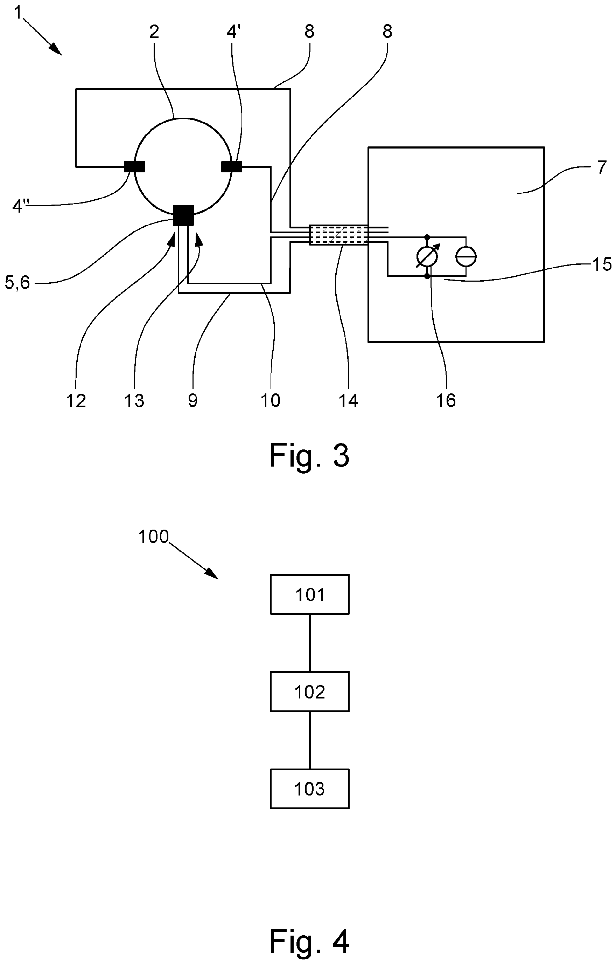

Fig. 3 zeigt eine weitere Ausgestaltung eines magnetisch-induktiven Durchflussmessgerätes 1. Im Gegensatz zu dem in Fig. 2 dargestellten Ausführungsbeispiel sind die beiden Elektrodenleitungen 8 und die Masseleitungen 9, 10 in einem Mehrleiterkabel 14 zusammengefasst. Dadurch, dass sämtliche Leitungen in einem Mehrleiterkabel 14 zusammengefasst sind, werden bei der Überprüfung der Masseleitungen 9, 10 zugleich die Elektrodenleitungen 8 mit überprüft. Ebenfalls im Unterschied zu Fig. 2 wird hier im Überprüfungsstromkreis ein Überprüfungsstrom angelegt und die abfallende Spannung gemessen.

Fig. 4 zeigt ein Blockdiagramm eines Verfahrens 100 zur Funktionsüberwachung eines in Fig. 1 dargestellten magnetisch-induktiven Durchflussmessgerätes. In einem Messschritt 101 führt die Auswerteeinheit des magnetisch-induktiven Durchflussmessgerätes wenigstens einen der beiden folgenden Verfahrensschritte durch:
- Einprägen eines Überprüfungsstroms in den Überprüfungsstromkreis und Messen der in dem Überprüfungsstrompfad abfallenden Spannung, oder
- Anlegen einer Überprüfungsspannung an den Überprüfungsstrompfad und Messen des im Überprüfungsstromkreis fließenden Stroms,

In einem Vergleichsschritt 102 vergleicht die Auswerteeinheit den gemessenen Wert für die abgefallene Spannung und/oder den fließenden Strom und/oder eine berechnete Impedanz des Überprüfungsstrompfades mit einem Referenzwert für die abfallende Spannung, den resultierenden Strom oder die Impedanz für den Gutzustand der Verbindung zwischen Masseelement und Auswerteeinheit. In einem Ausgabeschritt 103 gibt die Auswerteeinheit beim Abweichen der Werte über einen vorgegebenen Toleranzbereich hinaus ein Fehlersignal aus.

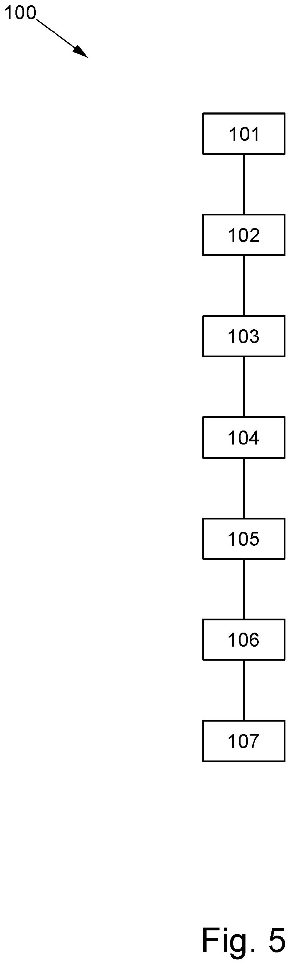

Fig. 5 zeigt eine Weiterentwicklung des in Fig. 4 dargestellten Verfahrens. Die ersten drei Verfahrensschritte 101, 102 und 103 werden bei dem hier dargestellten Verfahren ebenfalls durchgeführt. Das magnetisch-induktive Durchflussmessgerät, bei dem das hier dargestellte Verfahren durchgeführt wird, weist einen ersten Elektrodenmesspfad und einen zweiten Elektrodenmesspfad auf. wobei die erste Elektrode und das Masseelement Teil des ersten Elektrodenmesspfades sind und wobei die zweite Elektrode und das Masseelement Teil des zweiten Elektrodenmesspfades sind. In einem Ermittlungsschritt 104 ermittelt die Auswerteeinheit eine impedanzabhängige elektrische Größe des ersten Elektrodenmesspfades und/oder eine impedanzabhängige elektrische Größe des zweiten Elektrodenmesspfades. In einem Vergleichsschritt 105 vergleicht die Auswerteeinheit die ermittelten impedanzabhängigen elektrischen Größen miteinander und/oder mit einem vorgegebenen Vergleichswert. In einem Signalausgabeschritt 106 gibt die Auswerteeinheit bei einer festgestellten Abweichung über einen vorgegebenen Toleranzbereich hinaus ein Elektrodenfehlersignal aus. In einem Identifizierungsschritt 107 identifiziert die Auswerteeinheit die Elektrode, bei der die ermittelte impedanzabhängige elektrische Größe auf einen höheren Impedanzwert hinweist, als fehlerhafte Elektrode.

### Bezugszeichen

- 1: magnetisch-induktives Durchflussmessgerät
- 2: Messrohr
- 3: Magnetfelderzeugungseinrichtung
- 4: Elektroden
- 5: Masseelement
- 6: Masseelektrode
- 7: Auswerteeinheit
- 8: Elektrodenleitung
- 9: erste Masseleitung
- 10: zweite Masseleitung
- 11: Überprüfungsstromkreis
- 12: erster Anschluss
- 13: zweiter Anschluss
- 14: Mehrleiterkabel
- 15: Stromquelle
- 16: Spannungsmessgerät
- 17: Spannungsquelle
- 18: Strommessgerät
- 19: erster Elektrodenmesspfad
- 20: zweiter Elektrodenmesspfad
- 100: Verfahren
- 101: Messschritt
- 102: Vergleichsschritt
- 103: Ausgabeschritt
- 104: Ermittlungsschritt
- 105: Vergleichsschritt
- 106: Signalausgabeschritt
- 107: Identifizierungsschritt

## Patentansprüche

1. Magnetisch-induktives Durchflussmessgerät (1), mit einem Messrohr (2) zum Führen eines elektrisch leitfähigen Mediums, mit einer Magnetfelderzeugungseinrichtung (3) zum Erzeugen eines das Medium durchsetzenden Magnetfeldes, mit zwei Elektroden (4', 4") zum Abgreifen einer in dem Medium induzierten Messspannung, mit einem mit dem Medium elektrisch verbundenen Masseelement (5) und mit einer Auswerteeinheit (7), wobei die Elektroden (4) über Elektrodenleitungen (8) mit der Auswerteeinheit (7) verbunden sind und wobei das Masseelement (5) über eine erste Masseleitung (9) mit der Auswerteeinheit (7) verbunden ist zum Potentialausgleich zwischen dem elektrisch leitfähigen Medium und einem Bezugspotential der Auswerteeinheit (7), wobei
das Masseelement (5) zumindest mittelbar über eine zweite Masseleitung (10) mit der Auswerteeinheit (7) verbunden ist,
**dadurch gekennzeichnet,**
**dass** die erste Masseleitung (9) und die zweite Masseleitung (10) Bestandteil eines Überprüfungsstrompfades eines Überprüfungsstromkreises (11) zur Überprüfung der Verbindung zwischen Masseelement (5) und Auswerteeinheit (7) sind,
**dass** die Auswerteeinheit (7) derart ausgestaltet ist, dass sie die Verbindung zwischen Masseelement (5) und Auswerteeinheit (7) überprüft, wobei die Auswerteeinheit (7) derart ausgestaltet ist, dass sie in den Überprüfungsstromkreis (11) einen Überprüfungsstrom einprägt und die in dem Überprüfungsstrompfad abfallende Spannung misst, oder dass die Auswerteeinheit (7) derart ausgestaltet ist, dass sie eine Überprüfungsspannung an den Überprüfungsstrompfad anlegt und den im Überprüfungsstromkreis (11) fließenden Strom misst, und dass in der Auswerteeinheit (7) ein Referenzwert für die abfallende Spannung, den resultierenden Strom oder die gemessene Impedanz des Überprüfungsstrompfades für den Gutzustand der Verbindung zwischen Masseelement (5) und Auswerteeinheit (7) hinterlegt ist und die Auswerteeinheit (7) den gemessenen Wert mit dem Referenzwert vergleicht.

2. Magnetisch-induktives Durchflussmessgerät (1) nach Anspruch 1, **dadurch gekennzeichnet, dass** die erste Elektrode (4') und das Masseelement (5) einen ersten Elektrodenmesspfad (19) bilden und dass die zweite Elektrode (4") und das Masseelement (5) einen zweiten Elektrodenmesspfad (20) bilden und dass die Auswerteeinheit (7) derart ausgestaltet ist, dass sie eine impedanzabhängige elektrische Größe des ersten Elektrodenmesspfades (19) ermittelt und dass sie eine impedanzabhängige elektrische Größe des zweiten Elektrodenmesspfades (20) ermittelt und dass die Auswerteeinheit (7) ferner derart ausgestaltet ist, dass sie die ermittelten impedanzabhängigen elektrischen Größen miteinander oder mit einem vorgegebenen Referenzwert vergleicht und bei einer festgestellten Abweichung über einen vorgegebenen Toleranzbereich hinaus ein Fehlersignal ausgibt.

3. Magnetisch-induktives Durchflussmessgerät (1) nach einem der Ansprüche 1 oder 2, **dadurch gekennzeichnet, dass** das Masseelement (5) einen Anschluss (12) aufweist und dass die erste Masseleitung (9) über den Anschluss (12) mit dem Masseelement (5) verbunden ist und dass die zweite Masseleitung (10) mit der ersten Masseleitung (9) verbunden ist, sodass die zweite Masseleitung (10) mittelbar über die erste Masseleitung (9) mit dem Masseelement (5) verbunden ist.

4. Magnetisch-induktives Durchflussmessgerät (1) nach einem der Ansprüche 1 oder 2, **dadurch gekennzeichnet, dass** das Masseelement (5) einen ersten Anschluss (12) und einen zweiten Anschluss (13) aufweist und die erste Masseleitung (9) über den ersten Anschluss (12) mit dem Masseelement (5) verbunden ist und die zweite Masseleitung (10) über den zweiten Anschluss (13) mit dem Masseelement (5) verbunden ist.

5. Magnetisch-induktives Durchflussmessgerät (1) nach einem der Ansprüche 1 bis 4, **dadurch gekennzeichnet, dass** die Elektrodenleitungen (8) und die Masseleitungen (9, 10) in einem Mehrleiterkabel (14) zusammengefasst sind.

6. Verfahren (100) zur Funktionsüberwachung eines magnetisch-induktiven Durchflussmessgerätes, wobei das magnetisch-induktive Durchflussmessgerät ein Messrohr zum Führen eines elektrisch leitfähigen Mediums, eine Magnetfelderzeugungseinrichtung zum Erzeugen eines das Medium durchsetzenden Magnetfeldes, zwei Elektroden zum Abgreifen einer in dem Medium induzierten Messspannung, ein mit dem Medium elektrisch verbundenes Masseelement und eine Auswerteeinheit aufweist, wobei die Elektroden über Elektrodenleitungen mit der Auswerteeinheit verbunden sind und wobei das Masseelement über eine erste Masseleitung mit der Auswerteeinheit verbunden ist zum Potentialausgleich zwischen dem elektrisch leitfähigen Medium und einem Bezugspotential der Auswerteeinheit und wobei das Masseelement zumindest mittelbar über eine zweite Masseleitung mit der Auswerteeinheit verbunden ist, **dadurch gekennzeichnet,**
**dass** die erste Masseleitung und die zweite Masseleitung Bestandteil eines Überprüfungsstrompfades eines Überprüfungsstromkreises zur Überprüfung der Verbindung zwischen Masseelement und Auswerteeinheit sind,
**dass** in einem Messschritt (101) die Auswerteeinheit wenigstens einen der beiden folgenden Verfahrensschritte durchführt:
• Einprägen eines Überprüfungsstroms in den Überprüfungsstromkreis und Messen der in dem Überprüfungsstrompfad abfallenden Spannung, oder
• Anlegen einer Überprüfungsspannung an den Überprüfungsstrompfad und Messen des im Überprüfungsstromkreis fließenden Stroms,
**dass** in einem Vergleichsschritt (102) die Auswerteeinheit den gemessenen Wert für die abgefallene Spannung und/oder den fließenden Strom und/oder eine berechnete Impedanz des Überprüfungsstrompfades mit einem Referenzwert für die abfallende Spannung, den resultierenden Strom oder die Impedanz für den Gutzustand der Verbindung zwischen Masseelement und Auswerteeinheit vergleicht und
**dass** beim Abweichen der Werte über einen vorgegebenen Toleranzbereich hinaus in einem Ausgabeschritt (103) die Auswerteeinheit ein Fehlersignal ausgibt.

7. Verfahren (100) nach Anspruch 6, wobei das magnetisch-induktive Durchflussmessgerät einen ersten Elektrodenmesspfad und einen zweiten Elektrodenmesspfad aufweist, wobei die erste Elektrode und das Masseelement Teil des ersten Elektrodenmesspfades sind und wobei die zweite Elektrode und das Masseelement Teil des zweiten Elektrodenmesspfades sind, **dadurch gekennzeichnet, dass** in einem Ermittlungsschritt (104) die Auswerteeinheit eine impedanzabhängige elektrische Größe des ersten Elektrodenmesspfades und/oder eine impedanzabhängige elektrische Größe des zweiten Elektrodenmesspfades ermittelt,
dass in einem Vergleichsschritt (105) die Auswerteeinheit die ermittelten impedanzabhängigen elektrischen Größen miteinander und/oder mit einem vorgegebenen Vergleichswert vergleicht
und dass in einem Signalausgabeschritt (106) die Auswerteeinheit bei einer festgestellten Abweichung über einen vorgegebenen Toleranzbereich hinaus ein Elektrodenfehlersignal ausgibt.

8. Verfahren nach Anspruch 7, **dadurch gekennzeichnet, dass** in einem Identifizierungsschritt (107) die Elektrode, bei der die ermittelte impedanzabhängige elektrische Größe auf einen höheren Impedanzwert hinweist, als fehlerhafte Elektrode identifiziert wird.

## Claims

1. Magnetic-inductive flowmeter (1), having a measuring tube (2) for carrying an electrically conductive medium, having a magnetic field generator (3) for generating a magnetic field passing through the medium, having two electrodes (4', 4") for tapping a measuring voltage induced in the medium, having a ground element (5) electrically connected to the medium, and having an evaluation unit (7), wherein the electrodes (4) are connected to the evaluation unit (7) via electrode lines (8), and wherein the ground element (5) is connected to the evaluation unit (7) via a first ground line (9) for potential equalization between the electrically conductive medium and a reference potential of the evaluation unit (7),
wherein the ground element (5) is connected to the evaluation unit (7) at least indirectly via a second ground line (10),
**characterized in**
**that** the first ground line (9) and the second ground line (10) are part of a monitoring current path of a monitoring circuit (11) for monitoring the connection between the ground element (5) and the evaluation unit (7),
**that** the evaluation unit (7) is designed such that it monitors the connection between the ground element (5) and the evaluation unit (7), wherein the evaluation unit (7) is designed such that it impresses a monitoring current into the monitoring circuit (11) and measures the voltage drop in the monitoring circuit path, or that the evaluation unit (7) is designed such that it applies a monitoring voltage to the monitoring circuit path and measures the current flowing in the monitoring circuit (11),
and **that** a reference value for the voltage drop, the resulting current or the measured impedance of the monitoring circuit path is stored in the evaluation unit (7) for the go state of the connection between the ground element (5) and the evaluation unit (7), and the evaluation unit (7) compares the measured value with the reference value.

2. Magnetic-inductive flowmeter (1) according to claim 1, **characterized in that** the first electrode (4') and the ground element (5) form a first electrode measurement path (19) and that the second electrode (4") and the ground element (5) form a second electrode measurement path (20), and that the evaluation unit (7) is designed such that it determines an impedance-dependent electrical dimension of the first electrode measurement path (19) and that it determines an impedance-dependent electrical dimension of the second electrode measurement path (20), and that the evaluation unit (7) is further designed such that it compares the determined impedance-dependent electrical dimensions with one another or with a predetermined reference value and outputs an error signal in the event of a determined deviation beyond a predetermined tolerance range.

3. Magnetic-inductive flowmeter (1) according to any one of claims 1 or 2, **characterized in that** the ground element (5) has a terminal (12) and that the first ground line (9) is connected to the ground element (5) via the terminal (12) and that the second ground line (10) is connected to the first ground line (9), so that the second ground line (10) is indirectly connected to the ground element (5) via the first ground line (9).

4. Magnetic-inductive flowmeter (1) according to any one of claims 1 or 2, **characterized in that** the ground element (5) has a first terminal (12) and a second terminal (13), and the first ground line (9) is connected to the ground element (5) via the first terminal (12) and the second ground line (10) is connected to the ground element (5) via the second terminal (13).

5. Magnetic-inductive flowmeter (1) according to any one of claims 1 to 4, **characterized in that** the electrode lines (8) and the ground lines (9, 10) are combined in a multi-conductor cable (14).

6. Method (100) for function monitoring of a magnetic-inductive flowmeter, wherein the magnetic-inductive flowmeter has a measuring tube for carrying an electrically conductive medium, a magnetic field generator for generating a magnetic field passing through the medium, two electrodes for tapping a measuring voltage induced in the medium, a ground element electrically connected to the medium, and an evaluation unit, wherein the electrodes are connected to the evaluation unit via electrode lines, and wherein the ground element is connected to the evaluation unit via a first ground line for potential equalization between the electrically conductive medium and a reference potential of the evaluation unit, and wherein the ground element is connected to the evaluation unit at least indirectly via a second ground line, **characterized in**
**that** the first ground line and the second ground line are part of a monitoring current path of a monitoring circuit for monitoring the connection between the ground element and the evaluation unit,
**that**, in a measurement step (101), the evaluation unit performs at least one of the following two method steps:
• impressing a monitoring current in the monitoring circuit and measuring the voltage drop in the monitoring current path, or
• applying a monitoring voltage to the monitoring current path and measuring the current flowing in the monitoring current path,
**that**, in a comparison step (102), the evaluation unit compares the measured value for the voltage drop and/or the flowing current and/or a calculated impedance of the monitoring current path with a reference value for the voltage drop, the resulting current or the impedance for the go state of the connection between the ground element and the evaluation unit, and
**that**, if the values deviate beyond a predetermined tolerance range, the evaluation unit outputs an error signal in an output step (103).

7. Method (100) according to claim 6, wherein the magnetic-inductive flowmeter has a first electrode measurement path and a second electrode measurement path, wherein the first electrode and the ground element are part of the first electrode measurement path and wherein the second electrode and the ground element are part of the second electrode measurement path, **characterized in**
**that**, in a determination step (104), the evaluation unit determines an impedance-dependent electrical dimension of the first electrode measurement path and/or an impedance-dependent electrical dimension of the second electrode measurement path,
**that**, in a comparison step (105), the evaluation unit compares the determined impedance-dependent electrical dimensions with one another and/or with a predetermined comparison value
and **that**, in a signal output step (106), the evaluation unit outputs an electrode error signal in the event of a detected deviation beyond a predetermined tolerance range.

8. Method according to claim 7, **characterized in that**, in an identification step (107), the electrode for which the determined impedance-dependent electrical dimension indicates a higher impedance value is identified as a faulty electrode.

## Revendications

1. Débitmètre à induction magnétique (1), comprenant un tube de mesure (2) pour acheminer un milieu électriquement conducteur, un équipement de génération de champ magnétique (3) pour générer un champ magnétique traversant le milieu, deux électrodes (4', 4") pour prélever une tension de mesure induite dans le milieu, un élément de masse (5) relié électriquement au milieu, et une unité d'évaluation (7), dans lequel les électrodes (4) sont reliées par des conducteurs d'électrode (8) à l'unité d'évaluation (7), et dans lequel l'élément de masse (5) est relié à l'unité d'évaluation (7) par un premier conducteur de masse (9) pour une compensation de potentiel entre le milieu électriquement conducteur et un potentiel de référence de l'unité d'évaluation (7), dans lequel l'élément de masse (5) est relié à l'unité d'évaluation (7) au moins indirectement par un deuxième conducteur de masse (10),
**caractérisé en ce que** le premier conducteur de masse (9) et le deuxième conducteur de masse (10) font partie d'un trajet de courant de contrôle d'un circuit électrique de contrôle (11) pour contrôler la liaison entre l'élément de masse (5) et l'unité d'évaluation (7),
**en ce que** l'unité d'évaluation (7) est configurée de telle sorte qu'elle contrôle la liaison entre l'élément de masse (5) et l'unité d'évaluation (7), l'unité d'évaluation (7) étant configurée de façon à introduire un courant de contrôle dans le circuit électrique de contrôle (11) et à mesurer la tension qui chute sur le trajet de courant de contrôle, ou
**en ce que** l'unité d'évaluation (7) est configurée de telle sorte qu'elle applique une tension de contrôle au trajet de courant de contrôle et mesure le courant qui circule dans le circuit électrique de contrôle (11), et
**en ce que** dans l'unité d'évaluation (7), une valeur de référence pour la tension qui chute, le courant qui en résulte ou l'impédance mesurée du trajet de courant électrique est mémorisée pour l'état correct de la liaison entre l'élément de masse (5) et l'unité d'évaluation (7), et l'unité d'évaluation (7) compare la valeur mesurée avec la valeur de référence.

2. Débitmètre à induction magnétique (1) selon la revendication 1, **caractérisé en ce que** la première électrode (4') et l'élément de masse (5) constituent un premier trajet de mesure d'électrode (19), et **en ce que** la deuxième électrode (4") et l'élément de masse (5) constituent un deuxième trajet de mesure d'électrode (20), et **en ce que** l'unité d'évaluation (7) est configurée de telle sorte qu'elle détermine une grandeur électrique, dépendant de l'impédance, du premier trajet de mesure d'électrode (19), et **en ce qu'**elle détermine une grandeur électrique, dépendant de l'impédance, du deuxième trajet de mesure d'électrode (20), et **en ce que** l'unité d'évaluation (7) est en outre configurée de telle sorte qu'elle compare les grandeurs électrique, dépendant de l'impédance, déterminées entre elles ou avec une valeur de référence prédéfinie, et sort un signal d'erreur en cas d'écart constaté au-delà d'une plage de tolérance prédéfinie.

3. Débitmètre à induction magnétique (1) selon l'une quelconque des revendications 1 ou 2, **caractérisé en ce que** l'élément de masse (5) présente une borne (12), et **en ce que** le premier conducteur de masse (9) est relié par la borne (12) à l'élément de masse (5), et **en ce que** 1 deuxième conducteur de masse (10) est relié au premier conducteur de masse (9) de sorte que le deuxième conducteur de masse (10) est relié à l'élément de masse (5) indirectement par le premier conducteur de masse (9).

4. Débitmètre à induction magnétique (1) selon l'une quelconque des revendications 1 ou 2, **caractérisé en ce que** l'élément de masse (5) présente une première borne (12) et une deuxième borne (13), et le premier conducteur de masse (9) est relié par la première borne (12) à l'élément de masse (5), et le deuxième conducteur de masse (10) est relié par la deuxième borne (13) à l'élément de masse (5).

5. Débitmètre à induction magnétique (1) selon l'une quelconque des revendications 1 à 4, **caractérisé en ce que** les conducteurs d'électrode (8) et les conducteurs de masse (9, 10) sont regroupés dans un câble à multiconducteur (14).

6. Procédé (100) de surveillance du fonctionnement d'un débitmètre à induction magnétique, dans lequel le débitmètre à induction magnétique présente un tube de mesure pour acheminer un milieu électriquement conducteur, un équipement de génération de champ magnétique pour générer un champ magnétique traversant le milieu, deux électrodes pour prélever une tension de mesure induite dans le milieu, un élément de masse électriquement relié au milieu, et une unité d'évaluation, dans lequel les électrodes sont reliées à l'unité d'évaluation par des conducteurs d'électrode, et dans lequel l'élément de masse est relié par un premier conducteur de masse à l'unité d'évaluation pour la compensation de potentiel entre le milieu électriquement conducteur et un potentiel de référence de l'unité d'évaluation, et dans lequel l'élément de masse est relié à l'unité d'évaluation au moins indirectement par un deuxième conducteur de mesure,
**caractérisé en ce que** le premier conducteur de masse et le deuxième conducteur de masse font partie d'un trajet de courant de contrôle d'un circuit électrique de contrôle pour contrôler la liaison entre l'élément de masse et l'unité d'évaluation,
**en ce que** dans une étape de mesure (101), l'unité d'évaluation effectue au moins l'une des deux étapes de procédé suivantes :
• introduire un courant de contrôle dans le circuit électrique de contrôle et mesurer la tension qui chute sur le trajet de courant de contrôle, ou
• appliquer une tension de contrôle au trajet de courant de contrôle et mesurer le courant circulant dans le circuit électrique de contrôle,
**en ce que** dans une étape de comparaison (102), l'unité d'évaluation compare la valeur mesurée pour la tension qui chute et/ou le courant qui circule et/ou une impédance calculée du trajet de courant de contrôle avec une valeur de référence pour la tension qui chute, le courant qui en résulte ou l'impédance pour l'état correct de la liaison entre l'élément de masse et l'unité d'évaluation, et
**en ce qu'**en cas d'écart des valeurs au-delà d'une plage de tolérance prédéfinie, l'unité d'évaluation sort un signal d'erreur dans une étape de sortie (103).

7. Procédé (100) selon la revendication 6, dans lequel le débitmètre à induction magnétique présente un premier trajet de mesure d'électrode et un deuxième trajet de mesure d'électrode, dans lequel la première électrode et l'élément de masse font partie du premier trajet de mesure d'électrode, et dans lequel la deuxième électrode et l'élément de masse font partie du deuxième trajet de mesure d'électrode,
**caractérisé en ce que** dans une étape de détermination (104), l'unité d'évaluation détermine une grandeur électrique, dépendant de l'impédance, du premier trajet de mesure d'électrode et/ou une grandeur électrique, dépendant de l'impédance, du deuxième trajet de mesure d'électrode,
**en ce que** dans une étape de comparaison (105), l'unité d'évaluation compare les grandeurs électriques, dépendant de l'impédance, déterminées entre elles et/ou avec une valeur de comparaison prédéfinie,
et **en ce que** dans une étape de sortie de signal (106), l'unité d'évaluation sort un signal d'erreur d'électrode en cas d'écart constaté au-delà d'une plage de tolérance prédéfinie.

8. Procédé selon la revendication 7, **caractérisé en ce que** dans une étape d'identification (107), l'électrode à laquelle la grandeur électrique, dépendant de l'impédance, déterminée implique une valeur d'impédance supérieure est identifiée comme une électrode défectueuse.
